Europäisches Patentamt

European Patent Office

Office européen des brevets

(19)

(11) Veröffentlichungsnummer : **0 021 181**
**B1**

(12) **EUROPÄISCHE PATENTSCHRIFT**

(45) Veröffentlichungstag der Patentschrift :
16.02.83

(51) Int. Cl.³ : **G 01 R   5/16, G 01 D 11/12**

(21) Anmeldenummer : **80103147.7**

(22) Anmeldetag : **06.06.80**

(54) **Messwerk mit magnetischem Rotor.**

(30) Priorität : **25.06.79 DE 2925533**

(43) Veröffentlichungstag der Anmeldung :
**07.01.81 Patentblatt 81/01**

(45) Bekanntmachung des Hinweises auf die Patenterteilung : **16.02.83 Patentblatt 83/07**

(84) Benannte Vertragsstaaten :
**FR GB IT NL SE**

(56) Entgegenhaltungen :
**DE A 1 917 784**
**DE C 1 118 878**
**US A 1 456 517**
**US A 3 867 696**

(73) Patentinhaber : **VDO Adolf Schindling AG**
**Gräfstrasse 103**
**D-6000 Frankfurt/Main (DE)**

(72) Erfinder : **Stolzlechner, Albert**
**Am Kreuzacker 26**
**D-6056 Heusenstamm (DE)**

(74) Vertreter : **Könekamp, Herbert, Dipl.-Ing.**
**Sodener Strasse 9**
**D-6231 Schwalbach (DE)**

Messwerk mit magnetischem Rotov

Die Erfindung betrifft eine Meßeinrichtung mit an ein Zeigerwerk koppelbarem, in mindestens einer Richtung magnetisiertem Rotor, der in einem Spulenträger für die das Meßsignal aufnehmende Erregerwicklung gelagert ist, und mit einem justierbaren, am Spulenträger montierbaren Dauermagnet.

Für Kraftfahrzeuginstrumente sind Magnetmeßwerke bekannt, deren magnetischer Rotor gegenüber einem drehfest montiertem magnetisierten Ring drehbar in einem Spulenträger gelagert ist (DE-C 11 18 878). Intensität und Richtung der Magnetisierung des Magnetrings werden durch ein externes Magnetfeld eines Elektromagneten erzeugt, dessen Kern kurzzeitig vor Montage des Rotors eingebracht ist. Auf diese Weise kann der Ring nach Montage im Spulenträger justiert werden.

Das bekannte Meßwerk hat den Nachteil, daß der Spulenträger wegen der Öffnung zum Einführen des Elektromagnetkernes nicht abschließbar ist und daher bei Einbau einer Flüssigkeitsdämpfung zusätzlich koaxial zur Rotorachse ein gesonderter Raum für eine Dämpfungsflüssigkeit vorgesehen sein müßte. Außerdem ist die Lagerung des Rotors in bezug auf Abweichungen des Luftspaltes des Rotors zum Magnetring sehr empfindlich. Für funktionsfähige Tachometer, bei denen es auf einen entlang des Magnetringes gleichbleibenden Luftspalt ankommt, ist daher eine sehr präzise und kostenintensive Herstellung erforderlich.

Der Erfindung liegt die Aufgabe zugrunde, eine im Vergleich mit dem Bekannten wesentlich einfacher ausgebildete Meßeinrichtung mit unempfindlicherem Rotorlager zu schaffen, die einfacher dämpfbar und dessen am Spulenträger angeordneter Dauermagnet ohne Werkzeug einfach und genau justierbar und befestigbar ist. Dadurch soll das Meßwerk nicht nur kostengünstiger sondern auch noch kleiner und kompakter herstellbar sein.

Diese Aufgabe wird bei einer Einrichtung der eingangs genannten Art dadurch gelöst, daß mindestens eine Lagerung des Rotors unter Bildung eines flüssigkeitsdichten Raumes für die Dämpfungsflüssigkeit durch den Spulenträger abgeschlossen ist, und daß der Dauermagnet auf der Außenfläche des Spulenträgers in einer zum Justieren auswählbaren Richtung befestigbar ist. Das Magnetfeld eines Dauermagneten vorgegebener Koerzitivkraft ist dann ohne fremdes Hilfsfeld zum Justieren geeignet. Haltekräfte der Einschnappmontage dürfen gering sein, da sie den Dauermagnet nur vorläufig halten, bis der Spulenträger nach Befestigung des justierten Dauermagneten mit der Erregerwicklung belegt wird. Der Dauermagnet liegt daher bei einer besonders vorteilhaft fertigbaren Ausgestaltung der Erfindung unter der Erregerwicklung und wird vorläufig dadurch gehalten, daß er in Einschnappmontage in den Spulenträger einpreßbar ist.

In besonders vorteilhafter Ausgestaltung der Erfindung wird eine besonders gleichmäßig funktionierende Meßeinrichtung dadurch erzeugt, daß eine magnetische Abschirmung für Erregerwicklung und Dauermagnet vorgesehen ist.

Eine besonders einfach herstellbare, vorteilhafte Version der Erfindung ergibt sich dadurch, daß der Spulenträger aus spritzbarem Kunststoff hergestellt ist, in den der härtere Dauermagnet problemlos einpreßbar ist und dessen Magnetfeld ungehindert durch ihn auf den Rotor wirkt.

Eine besonders vorteilhafte Ausgestaltung der Erfindung ergibt sich dadurch, daß der Dauermagnet eine in Richtung seiner längsten Ausdehnung magnetisierte, rechteckige Platte ist, und daß der Spulenträger einen zur Einschnappmontage mit den Ecken dieser Platte geeigneten Rand hat, weil Dauermagnete dieser Form günstig zu beziehen oder herzustellen und einfach zu montieren sind. Eine besonders einfach justierbare Meßeinrichtung hat vorteilhaft im Zentrum der Platte eine kreisförmige Ausnehmung und im Zentrum des kreisförmig ausgebildeten Randes einen Ansatz, mit dem die Platte vor endgültiger Befestigung drehbar geführt ist.

Eine weitere vorteilhafte Ausgestaltung der Erfindung besteht darin, daß die Rotorwelle in einer in den Spulenträger einlegbaren, nicht magnetisierbaren Metallplatte gelagert ist, um die Lebensdauer der Führung des Rotors im Spulenträger erheblich zu verlängern und Lagerreibungen zu verringern. Darüber hinaus kann die metallische Lagerplatte vorteilhaft dadurch noch ausgestaltet werden, daß ein Schlitz als Führung für einen Anschlagstift des Rotors vorgesehen ist, von dem ein Anzeigebereich des Zeigerwerkes auf einen vorbestimmbaren Winkel eingrenzbar ist ; denn es hat sich gezeigt, daß den Meßsignalen am Rand des Meßbereiches geringere Bedeutung zukommt, so daß es andererseits ausreicht, Werte im Zentrum des Anzeigebereiches anzuzeigen. Dadurch wird ein Anzeigen von Werten vermieden, die mit Fehlern behaftet sein können.

Weitere Ausgestaltungen der Erfindung werden anhand des in der Zeichnung schematisch dargestellten Ausführungsbeispieles näher erläutert. Es zeigen :

Figur 1 in Draufsicht die Seite des Spulenträgers, auf dem ein Dauermagnet justierbar befestigt ist und

Figur 2 einen Querschnitt durch den die Erfindung kennzeichnenden Ausschnitt der Meßeinrichtung.

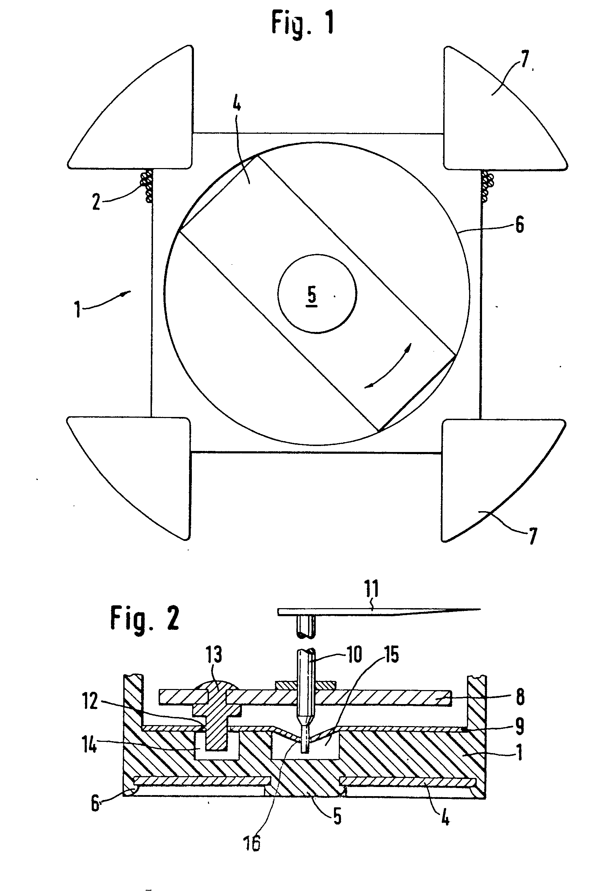

Bei dem in Figur 1 dargestellten Spulenträger 1 sind im Schnitt nur einige Windungen 2 der Erregerwicklung gezeigt, um den unter der Erregerwicklung angeordneten, für die Erfindung wesentlichen Dauermagnet 4 erkennen zu können. Der Dauermagnet 4 ist eine rechteckige Platte mit einer zentralen kreisförmigen Ausnehmung. Mit dieser Ausnehmung wird der Dauermagnet 4 auf einem Ansatz 5 des aus spritzbarem Kunststoff hergestellten Spulenträger 1 in Pfeilrichtung drehbar geführt. Dabei ist der Dauermagnet 4 auf dem Ansatz 5 gegenüber dem Spulenträger 1 drehbar geführt, um sein Magnetfeld so auszurichten, bis der — bereits montierte — in Figur 2 erkennbare Rotor 8 auf der entgegengesetzten Seite des Spulenträgers 1 ein dadurch wählbares Meßverhalten hat. Der Dauermagnet 4 wird also bei montiertem Rotor justiert, um störende Fertigungseinflüsse weitgehend auszuschließen.

Im Ausführungsbeispiel der Figur 1 ist der Dauermagnet als rechteckige magnetische Platte mit vorgegebener Koerzitivkraft ausgebildet. Eine bevorzugte Ausführungsform hat einen 12 mm langen, 4 mm breiten und 0,4 mm dicken Stabmagneten der Koerzitivkraft ca. 300 Ampere pro Meter. Derartige Magnete können aus einer Fe/Co/V-Legierung hergestellt werden, die unter der Handelsbezeichnung « Coerflex » (Warenzeichen) käuflich sind.

Zur vorläufigen Montage des Dauermagneten 4 ist in den Spulenträger 1 ein kreisförmiger zur Einschnappmontage geeigneter Rand 6 eingeformt. Später wird der Dauermagnet 4 von der auf dem Spulenträger 1 zwischen den Flanschen 7 gewickelten Erregerwicklung gehalten.

Figur 2, in der entsprechende Teile mit den gleichen Bezugszeichen versehen sind, zeigt die Lage des Dauermagneten 4 gegenüber dem Rotor 8 im Spulenträger 1. In diesem seitlichen Schnittbild sind die Spulenflansche 7 und die Erregerwicklung 2 aus Übersichtlichkeitsgründen weggelassen worden. Der Schnittdarstellung ist aber zu entnehmen, daß in den aus Kunststoff spritzbaren Spulenträger 1 eine lagerplatte 9 eingelegt ist, von der die Welle 10 des Rotors in einer Lagerung 16 drehbar geführt ist. Es ist ferner ersichtlich, daß die Welle 10 mittelbar oder unmittelbar mit einem Zeiger 11 verbunden ist.

Die Lagerplatte 9 hat ferner einen kreisförmigen Schlitz 12, von dem der Anzeigebereich des Meßwerkes mit Hilfe eines in diesem Schlitz 12 geführten Stiftes 13 des Rotors 8 eingegrenzt wird. Ein besonders einfach herstellbarer Anschlag 13 ist verwendbar, wenn in dem Spulenträger 1 parallel zum Schlitz 12 eine entsprechende Führung 14 mit eingespritzt ist, in den ein in der Länge variabler Anschlagstift 13 beliebig tief ragen kann.

Die Schnittdarstellung zeigt weiter noch Einzelheiten des Spulenträgers 1 für die Einschnappmontage, die aus hintergreifenden Haken bestehen, von denen der magnetische Dauermagnet 4 nach Justierung zur vorläufigen Montage bis zum Anbringen der Erregerwicklung 2 gehalten wird.

Bei der neuen Meßeinrichtung ist kein gesondert herzustellender und zusätzlichen Platz benötigender Raum zur Aufnahme einer Dämpfungsflüssigkeit mehr erforderlich, denn die — nicht gezeichnete — Dämpfungsflüssigkeit liegt zusammen mit dem Ende der Rotorwelle 10 in einem vom Spulenträger 1 abgeschlossenen Raum 15. Die Dämpfung kann wesentlich durch vergrößerte Wirkungsflächen verbessert werden.

Bei der Meßeinrichtung der Erfindung könnte eine in der Zeichnung nicht erkennbare verschließbare Öffnung zum nachträglichen Einbringen der Dämpfungsflüssigkeit vorgesehen sein.

Die im einzelnen erläuterte Meßeinrichtung ist nicht nur besonders gut zum Einsatz für Tachometer geeignet, sondern auch für andere Meßwerke mit von außen durch Dauermagnete justierbare Systeme.

## Ansprüche

1. Meßeinrichtung mit an ein Zeigerwerk (10, 11) koppelbarem, in mindestens einer Richtung magnetisiertem Rotor (8), der in einem Spulenträger (1) für die das Meßsignal aufnehmende Erregerwicklung (2) gelagert ist, und mit einem justierbaren, am Spulenträger montierbarem Dauermagneten (4), dadurch gekennzeichnet, daß mindestens eine Lagerung (16) des Rotors (8) unter Bildung eines flüssigkeitsdichten Raumes (15) für die Dämpfungsflüssigkeit durch den Spulenträger (1) abgeschlossen ist, und daß der Dauermagnet (4) auf der Außenfläche des Spulenträgers (1) in einer zum Justieren auswählbaren Richtung befestigbar ist.

2. Meßeinrichtung nach Anspruch 1, dadurch gekennzeichnet, daß der Dauermagnet (4) unter der Erregerwicklung (2) liegt und in Einschnappmontage in den Spulenträger (1) einpreßbar ist.

3. Meßeinrichtung nach Anspruch 1 oder 2, dadurch gekennzeichnet, daß eine magnetische Abschirmung für Erregerwicklung (2) und Dauermagnet (4) vorgesehen ist.

4. Meßeinrichtung nach einem der Ansprüche 1 bis 3, dadurch gekennzeichnet, daß der Spulenträger (1) aus spritzbarem Kunststoff hergestellt ist.

5. Meßeinrichtung nach Anspruch 1 bis 4, dadurch gekennzeichnet, daß der Dauermagnet (4) eine in Richtung seiner längsten Ausdehnung magnetisierte, rechteckige Platte (4) ist, und daß der Spulenträger (1) einen zur Einschnappmontage mit Ecken dieser Platte (4) geeigneten Rand hat.

6. Meßeinrichtung nach Anspruch 5, dadurch gekennzeichnet, daß im Zentrum der Platte (4) eine kreisförmige Ausnehmung und im Zentrum des kreisförmig ausgebildeten Randes (6) ein Ansatz (5) vorgesehen ist, mit dem die Platte (4) vor endgültiger Befestigung drehbar geführt wird.

7. Meßeinrichtung nach einem der vorhergehenden Ansprüche, dadurch gekennzeichnet, daß die Rotorwelle (10) in einer in den Spulenträger (1) einlegbaren, nicht magnetisierbaren Metallplatte (9) gelagert ist.

8. Meßeinrichtung nach Anspruch 7, dadurch gekennzeichnet, daß die Metallplatte (9) einen Schlitz als Führung (12) für einen Anschlagstift (13) des Rotors (8) hat, von dem ein Anzeigebereich des Zeigerwerks auf einen vorbestimmbaren Winkel eingrenzbar ist.

## Claims

1. Measuring device with a rotor (8) which can be coupled to a pointer mechanism (10, 11) and is magnetised in at least one direction and which is mounted in a coil holder (1) for the exciting winding (2) receiving the measuring signal, and with an adjustable permanent magnet (4) which can be mounted on the coil holder, characterised in that at least one mounting (16) of the rotor (8) is shut off by the coil holder (1) to form a fluid-tight space (15) for the damping fluid, and in that the permanent magnet (4) can be fastened to the outer surface of the coil holder (1) in a direction selectable for the purpose of adjustment.

2. Measuring device according to Claim 1, characterised in that the permanent magnet (4) is located under the exciting winding (2) and can be pressed into the coil holder (1) by snap-in fitting.

3. Measuring device according to Claim 1 or 2, characterised in that a magnetic shield is provided for the exciting winding (2) and permanent magnet (4).

4. Measuring device according to one of Claims 1 to 3, characterised in that the coil holder (1) is made of plastic which can be injection-moulded.

5. Measuring device according to Claims 1 to 4, characterised in that the permanent magnet (4) is a rectangular plate (4) magnetised in the direction of its longest extension, and in that the coil holder (1) has an edge suitfor a snap-in fitting with corners of this plate (4).

6. Measuring device according to Claim 5, characterised in that in the centre of the plate (4) there is a circular recess and in the centre of the circular edge (6) there is a projection (5) by means of which the plate (4) is guided rotatably before being finally fastened.

7. Measuring device according to one of the preceding claims, characterised in that the rotor shaft (10) is mounted in a non-magnetisable metal plate (9) which can be inserted into the coil holder (1).

8. Measuring device according to Claim 7, characterised in that the metal plate (9) has a slot as a guide (12) for a stop pin (13) of the rotor (8), by means of which an indicating range of the pointer mechanism can be limited to an angle which can be predetermined.

## Revendications

1. Dispositif de mesure qui comprend un rotor magnétisé suivant, au moins, une direction, pouvant être accouplé à un mécanisme d'aiguille indicatrice (10, 11), ledit rotor (8) étant logé dans un porte-bobine (1) supportant l'enroulement d'excitation (2) recevant le signal de mesure, et un aimant permanent (4) ajustable et pouvant être monté sur ledit porte-bobine, dispositif caractérisé en ce qu'au moins un palier (16) du rotor (8) est entièrement entouré par le porte-bobine (1), ce qui forme en même temps une chambre étanche (15) pour le liquide d'amortissement, et en ce que l'aimant permanent (4) peut être fixé sur la surface extérieure du porte-bobine (1) suivant une direction pouvant être choisie aux fins d'ajustage.

2. Dispositif de mesure selon la revendication 1, caractérisé en ce que l'aimant permanent (4), est placé sous la bobine d'excitation (2) et peut être introduit dans une monture à encliquetage ou à ressort du porte-bobine (1).

3. Dispositif de mesure selon la revendication 1 ou 2, caractérisé en ce qu'il comprend un écran de blindage magnétique pour l'enroulement d'excitation (2) et l'aimant permanent (4).

4. Dispositif de mesure selon l'une quelconque des revendications 1 à 3, caractérisé en ce que le porte-bobine (1) est en une matière plastique pouvant être moulée par injection.

5. Dispositif de mesure selon l'une quelconque des revendications 1 à 4, caractérisé en ce que l'aimant permanent (4) est une plaquette rectangulaire, magnétisée dans la direction de sa plus grande dimension, et en ce que le porte-bobine (1) comporte un bord convenant pour supporter par encliquetage les coins de cette plaquette (4).

6. Dispositif de mesure selon la revendication 5, caractérisé en ce qu'au centre de la plaquette (4) est prévu un évidement circulaire, tandis qu'au centre du bord circulaire (6) est prévu un prolongement (5) permettant de tourner la plaquette (4) avant sa fixation définitive.

7. Dispositif de mesure selon l'une quelconque des revendications précédentes, caractérisé en ce que l'arbre (10) du rotor est supporté par une plaquette métallique non magnétique (9) pouvant être incorporée dans le porte-bobine (1).

8. Dispositif de mesure selon la revendication 7, caractérisé en ce que la plaquette métallique (9) présente une fente de guidage (12) destinée à une goupille-butée (13) du rotor (8), qui permet de limiter à un angle prédéterminé l'amplitude du déplacement du mécanisme indicateur.

# Fig. 1

# Fig. 2